# EUROPEAN PATENT SPECIFICATION

(11) **EP 3 865 292 B1**
(45) Date of publication and mention of the grant of the patent: **07.06.2023**
(21) Application number: 21155618.8
(22) Date of filing: 05.02.2021
(51) Int. Cl.: B29D 30/38, B29B 15/14, B29B 15/12

(54) **A PLASMA CORD COATING DEVICE**
PLASMAKORDBESCHICHTUNGSVORRICHTUNG
DISPOSITIF DE REVÊTEMENT DE CORDON DE PLASMA

(30) Priority: 12.02.2020 US 202062975504 P
(43) Date of publication of application: 18.08.2021
(73) Proprietor: The Goodyear Tire & Rubber Company, Akron, OH 44316 (US); Vlaamse Instelling voor Technologisch Onderzoek NV (VITO NV), 2400 Mol (BE)
(72) Inventor: SIFFER, Frederic Gerard Auguste, L-7542 Mersch (LU); VANGENEUGDEN, Dirk Leo, B-3630 Maasmechelen (BE); VERHEYDE, Bert, B-3500 Hasselt (BE); VAN HOOF, Erwin Constant Maria, B-2470 Retie (BE)
(74) Representative: Kutsch, Bernd

(56) References cited:
- WO-A1-2012/004175
- US-A1- 2011 244 139

## Description

### Field of the invention

The present invention is directed to a plasma cord coating device, in particular for plasma coating reinforcement cords for tires and other rubber products. The present invention relates also to a method of plasma coating cords and a method of using a plasma cord coating device to coat tire cords. Furthermore, the present invention is directed to a cord reinforced product obtained by said method.

### Background

Rubber articles are typically reinforced with various types of reinforcing materials, such as textile, glass or steel fibers, to provide basic strength, shape, stability and resistance to bruises, fatigue, and heat. These fibers may be twisted into plies and cabled into cords. Rubber tires of various constructions as well as various industrial products such as conveyor belts, power transmission belts, air springs, hoses, seals, bumpers, mountings, and diaphragms can be prepared using such cords.

US 2011/0244139 A1 discloses a device for plasma treatment of tire cords, the device comprising a plasma generator where atmospheric plasma can be generated from an atomized mixture, the tire cord can be unwound from a spool and conveyed through the plasma generator. In a particular example, a dielectric barrier discharge apparatus is disclosed, said apparatus comprising a quartz tube with aluminum tape electrodes wrapped at a spaced interval on the exterior of the tube. A first electrode is connected to a high voltage power supply and a second electrode is grounded. A steel cord is extended through the interior of the quartz tube and held stationary. Application of high voltage to the first electrode ignites a plasma in the quartz tube.

Manufacturers of reinforced rubber articles have long realized the importance of interfacial adhesion between the reinforcement and the rubber environment in which it is embedded. Polymeric reinforcing elements, such as polyester and polyamide (nylon) cords, are typically treaded with a resorcinol/formaldehyde/latex (RFL) dip to improve adhesion to the rubber in which the polymeric reinforcing element is embedded. Steel reinforcing elements are typically brass plated to attain needed adhesion characteristics to enable them to function effectively for use in tires and in other reinforced rubber articles. It is important for the reinforcing element to exhibit a high level of adhesion to the rubber initially and after it has aged in the rubber article over time. In other words, it is necessary for the reinforcing element to have both good original and aged adhesion characteristics. In addition, the compounds used to coat these reinforcements are usually specially formulated to develop a higher level of adhesion. For example, many tire manufacturers use various cobalt salts as bonding promoters in their steel cord coats, as well as relatively high ratios of sulfur cure accelerators. The bonding promoters are added through compounding. To achieve a maximum bonding strength, an excess amount of cobalt salt is often added to the cord coat. Since only a very small portion of the cobalt salt may be engaged in the rubber-metal interfacial bonding reaction, most of the cobalt salts remain in the compound as excess cobalt without any contribution to bonding. The cobalt compounds that are used in such applications are typically expensive and may even cause aging problems of the rubber when used in excess. The use of such cobalt compounds may also have objectionable environmental effects.

Improving the adhesion of reinforcement cords to rubber while simultaneously improving the properties of the coat compounds and reducing their cost continues to be an important objective in the tire and rubber industry.

### Summary of the invention

One object of the present invention involves providing a cord coating device which is able to rapidly plasma coat cords, as for instance required in the mass production of tire cord reinforcements.

Another object of the present invention may be to provide a plasma cord coating device which can be continuously used with long maintenance and/or cleaning intervals.

Another object of the present invention may be to provide a plasma cord coating device exhibiting limited fouling in the plasma deposition zone.

The present invention is defined by independent claim 1. Further preferred embodiments are provided in the dependent claims as well as in the summary and description herein below.

Thus, a first aspect of the present invention relates to a plasma cord coating device comprising a pair of opposite and parallel plate electrodes having a first electrode and a second electrode, a pair of planar and parallel dielectric barriers including a first dielectric barrier and a second dielectric barrier, wherein the first electrode is covered by the first dielectric barrier on a side facing the second electrode and the second electrode is covered by the second dielectric barrier on a side facing the first electrode so as to form a gap between the first and the second dielectric barriers. Moreover, the device comprises a pair of driven conveyor (belt) foils comprising a first foil and a second foil, wherein the first foil (movably) extends through the gap and covers the first dielectric barrier and the second foil (movably) extends through the gap and covers the second dielectric barrier so as to form a (plasma) treatment zone between the first foil and the second foil (in the gap). Furthermore, the device has transport means for continuously transporting, in a direction of transport and spaced apart from the first foil and the second foil, at least one cord through the plasma treatment zone. A gas supply means is provided for directing or injecting gas into the plasma treatment zone, wherein said gas supply means is positioned upstream of the plasma treatment zone with respect to the direction of transport. This may also prevent surrounding air from entering into the gap. The direction of transport may be understood as a direction in parallel to the (length/extension of) cords.

The coating device can also be described as atmospheric pressure plasma cord coating device or more specifically also as dielectric barrier atmospheric pressure plasma cord coating device. The device according to this aspect of the invention allows for continuously transporting cords to be coated through the plasma treatment zone, respectively the electrode gap. In addition, the conveyor foils allow a removal of fouling material out of the treatment zone so that the conditions between the electrodes and the dielectric barriers can be maintained on a similar level without requiring stopping the system for cleaning purposes. Moreover, the cords are continuously transported through the treatment zone without contacting the foils covering the dielectric barriers. Such a contactless transport allows for coating the cords from all sides in the treatment zone such that only one run through the system is required for fully and uniformly coating the cord from all sides. In addition, the gas can be directly injected into the plasma treatment zone between the two foils. In other words, the two foils define or delimitate a space between them, in which the electrodes create a plasma so that the gas, or elements thereof, injected upstream the plasma treatment zone can be deposited on the cords before leaving the treatment zone.

In one embodiment, the transport means are adapted to transport at least two spaced apart and plane-parallel cords in parallel to the first and the second electrodes through the plasma treatment zone, spaced apart from the first foil and the second foil. Transporting multiple parallel cords (in parallel to the transport direction) through the treatment zone increases the productivity of the system. Moreover, such an arrangement allows coating of the cords from both sides by one run through the treatment zone. In a preferred example from 3 to 20 cords are transportable simultaneously in parallel through the treatment zone.

In another embodiment, a first roller is arranged upstream of the gap for guiding the first foil into the gap and wherein a second roller is arranged upstream of the gap for guiding the second foil into the gap. A third roller may be arranged downstream of the gap for guiding the first foil out of the gap and/or a fourth roller may be arranged downstream the gap for guiding the second foil out of the gap. One or more of such rollers could be (e.g. electrically) driven for moving the foils, for instance continuously, through the gap. The foils may for example move with a speed ranging from 10⁻⁵ m/s to 10⁻¹ m/s (preferably 10⁻⁴ to 10⁻² m/s) through the gap. Whenever, reference is made herein to upstream, this shall mean upstream in relation to the transporting direction of the cords. Downstream means downstream in relation to the transporting direction of the cords.

In still another embodiment, the gas supply means is positioned upstream of the first and the second rollers. This helps to efficiently inject the gas into the plasma treatment zone.

In still another embodiment, at least one of the foils is a closed band guided endlessly over at least two rollers into the gap and out of the gap.

For instance, the coating device further includes cleaning means for cleaning a foil after having left the gap and before guiding the foil again into the gap. The cleaning means could comprise mechanical scrapers and/or at least one bath (e.g. with solvents) for removing fouled material from the foils.

In yet another embodiment, the device is configured in a manner that at least one of the foils is unwindable from a first storage roll and is recoilable on a second storage roll. Optionally, a cleaning step or cleaning means could be present before recoiling as described above. However, in one embodiment the foil comprising plasma depositions is coiled on a storage roll and could preferably be one or more of: scrapped, recycled and/or cleaned remotely.

In still another embodiment, the gas supply means comprises one or more of: a slot (for injecting gas) arranged perpendicularly to the direction of transport, or a plurality of nozzles arranged perpendicularly to the direction of transport. For instance, the slot or the nozzles could point into the plasma treatment zone. Such a slot or a plurality of nozzles may help to achieve a homogenous gas distribution over the width of the treatment zone.

In yet another embodiment, at least one of the electrodes is cooled by a cooling means on a backside of the respective electrode opposite to the gap. As a continuous coating process is desirable, such a cooling means can help to allow for continuous coating conditions, avoiding varying electrode power and/or temperature variations, and thus varying plasma coating properties.

In still another embodiment, the backside of at least one of the electrodes is in direct contact with a cooling liquid reservoir. Preferably, the cooling liquid is electrically isolating, such as deionized water. In another embodiment, cooling tubes could be in contact with the backside of the electrodes (with respect to the gap), in particular in a meandering manner.

In still another embodiment, a distance between the first electrode and the second electrode is adjustable, e.g. by manually or electrically driven adjusting means. A typical "gap width" used for the coating of cords, which is also described herein as gap height h, ranges from about 1 mm to 10 mm, preferably from 1.5 mm to about 5 mm, or even more preferably between 2 mm and 4 mm. However, in case coating of objects with a larger thickness is envisaged, the gap width may be different and be adapted to the thickness of the object. A typical gap width for larger conductive objects may be up to 20 mm. Preferably, the first foil runs with a distance of less than 1 mm, preferably between 0 mm and 0.5 mm over the first dielectric barrier, same distances apply for the second foil and the second dielectric barrier. In a preferred embodiment, said distance is zero so that the foil runs in direct contact to the dielectric barrier over the dielectric barrier. The same may apply to the second foil and the second dielectric barrier. In general, preferably, the foils extend in parallel to the dielectric barriers and/or electrodes through the gap. The plasma treatment zone may preferably have a height or distance d between both foils which ranges from 1 mm to 10 mm, 1.5 mm to 5 mm, 2 mm to 4 mm or from 2.5 mm to 3.5 mm. It shall be clear that in case coating of an object with a larger thickness is to be carried out, the distance between the foils may be adapted accordingly.

The diameter of the cords to be coated may vary within wide ranges. The minimum diameter will usually be at least 0.05 mm. The maximum diameter will usually correspond to the distance between the first foil and the second foil minus 0.2 mm.

In still another embodiment, at least one of i) the first electrode and the first dielectric barrier, and ii) the second electrode and the second dielectric barrier is mounted on a movable support allowing adjusting a height h of the gap (e.g. essentially perpendicular to the direction of transport). It is also possible that the first foil is moved together with the first electrode and the first dielectric barrier and/or the second foil is moved together with the second electrode and the second dielectric barrier, resulting in an adjustment of the distance d between the two foils and of the height h of the gap. For instance, rolls or rollers guiding the foils could also be on the same or separate movable support.

In another embodiment, the device further comprises an exhaust means downstream from the gap, e.g. for exhausting gases leaving the treatment zone downstream of the gap. In an example, the exhaust means could comprise at least one pipe comprising one or more apertures or slots, arranged in a direction transvers to the direction of transport.

In another embodiment, the foils are made of a dielectric material, such as a polymeric dielectric material. The foils can have a thickness which is within the range of 0.010 mm to 3 mm, 0.02 mm to 2 mm, 0.025 mm to 1 mm, or 0.025 mm to 0.5 mm.

In yet another embodiment, at least one of the foils is made of at least one polymer, preferably polyimide. Polyimide has excellent thermal and dielectric properties, making it a preferred material for the implementation of the present invention. However, alternatively non-woven fabrics made of aramid, glass and more generally heat-resistant materials could be utilized as well or for instance other materials listed further herein below.

In yet another embodiment, at least one of the foils is made of one or more of the following materials: polyimides, polyamide-based polymers, fluorinated polymers, silicone-based polymers, and polyesters, such as polyethylene terephthalate (PET) or polyethylene naphthalate (PEN). In addition, one or more of said materials may be reinforced, in particular fiber reinforced. Optionally, one or more of the foils may comprise multiple layers comprising one or more of the above materials.

In still another embodiment, the foils cover at least essentially the whole width and length of the dielectric barriers. Additionally, or alternatively, the foils cover at least essentially the whole width and length of the electrodes. This helps to reduce the need to frequent clean the device.

Independently, the dielectric barriers could cover at least essentially the whole width and length of the electrodes. Covering does not necessarily mean that the foils or barriers are in contact with the barriers or electrodes, respectively. However, it may be desirable to have the foils in contact with the respective dielectric barrier material to avoid forming an unwanted plasma between the foil and the (adjacent) dielectric barrier. The electrodes are preferably also as much as possible in contact with the respective dielectric barriers. In an example, the electrodes can be mechanically pushed or biased against the dielectric barrier with biasing means such as spring elements. Moreover, the dielectric barriers could in an example be layers coated onto the electrodes or separate plates attached to or spaced apart from the electrodes. Dielectric materials could in general include glass, quartz, polymeric or ceramic material. However, these materials should be understood as non-limiting examples.

In another embodiment, the device comprises at least two cords extending in parallel and coplanar through the gap with an equal distance to the first electrode and the second electrode, and optionally with an essentially equal distance to the first dielectric barrier and the second dielectric barrier and even typically with an essentially equal distance to the first foil and the second foil. While such equal distances are not mandatory, they may support a homogenous coating of the cords.

In yet another embodiment, the device further comprises a cord guiding means arranged upstream and/or downstream of the gap, wherein the cord guiding means may comprise a comb-shaped guide having a plurality of teeth for holding cords spaced apart and at essentially equal distance from the electrodes (or in the same plane) between the teeth.

In still another embodiment, the device may alternatively or additionally comprise a cord guiding means including a roller having circumferential grooves for guiding cords. In particular, such a roller may be arranged with its axle of rotation perpendicular to the transport direction and thus perpendicular to the direction of extension of the cords. The roller surface or said comb-shaped guide may be in electrically conductive contact (in electrical communication) with the cords and optionally be grounded, which allows to ground the guided cords if desired. In one embodiment, one or more electrically conductive cords are grounded and/or both electrodes are at (high) voltage. In another embodiment, in case of coating one or more non-conductive cords, both electrodes can be at different voltages, preferably one grounded and one at (high) voltage. Both electrodes may also be at opposite (high) voltage. In case of conductive materials to be coated, a more homogeneous coating may be obtained when energizing both electrodes which then discharge on the grounded wire (for coating homogeneity). For non-conductive cords, one of the electrodes can be either grounded or energized at a different, in particular sinusoidal, voltage amplitude (bias voltage) so as to ensure a flow of charges from one electrode to the other since such charges cannot be conducted by the non-conductive cord.

In yet another embodiment, the device further comprises a power supply connected to at least one of the electrodes for creating or igniting the plasma in the plasma treatment zone within the gap.

In yet another embodiment, the device comprises a means for grounding at least one of the electrodes and/or the cords to be coated. In particular, this may be desirable if the cords to be coated are metal cords. Then the cords could be, for instance, grounded with the guiding means described herein above.

In another aspect of the invention, a plasma coating system is provided which comprises a multiple (two or more) of said plasma coating devices in series. In particular, this may help to increase the speed of transport of the cords through the device(s) / system. The cords may be guided via rollers from one plasma cord coating device to the next one.

In another aspect of the invention, a method of using the device or system for plasma coating (simultaneously) multiple cords, in particular tire cords, and more particularly steel cords is provided.

In yet another aspect of the invention, a method for plasma coating at least one cord is provided including one or more of the following steps:
Unwinding the least one cord to be plasma coated from a spool, preferably arranged in a creel;
Preferably continuously, moving the at least one cord through a plasma treatment zone of a plasma coating device and plasma coating the cord in the plasma treatment zone,
wherein the plasma treatment zone is delimited by a pair of conveyor foils arranged in a dielectric barrier discharge gap of the plasma coating device and covering the dielectric barriers of the plasma coating device against plasma depositions, and
wherein the conveyor foils, preferably continuously, convey material plasma deposited onto the foils out of the plasma treatment zone, and wherein the wire is moved or transported without contact to the foils through the plasma treatment zone.

This can preferably involve continuously, introducing a (mixture of a) carrier gas (such as noble gases, e.g. argon, neon, xenon, krypton, helium; nitrogen, nitrous oxide, air, oxygen, carbon dioxide (CO₂), hydrogen or other suitable gases) and a "coating material gas" (such as gaseous hydrocarbons, e.g. ethylene, acetylene or methane), a coating material vaporized precursor, a coating material vapor and/or a coating material aerosol, or in other words an aerosolized precursor, preferably upstream the plasma treatment zone, into the plasma treatment zone; and rewinding the at least one plasma coated cord on another spool.

In an embodiment, the cord may be moved at a speed ranging from 1 m/min up to 200 m/min, preferably to 100 m/min.

In another embodiment, multiple cords are moved plane-parallelly (i.e. in parallel and in one plane) through the plasma treatment zone, spaced apart from each other and spaced apart from the conveyor foils (such that the cords are coated from all sides during one run through the treatment zone). In particular, all cords may have an essentially equal distance to electrodes, the dielectric barriers and/or the foils when passing through the treatment zone.

In another aspect of the invention, a cord reinforced product is provided, the product comprising a cord obtained in accordance with the above method or one or more of its embodiments.

In one embodiment, the product is selected from a tire, a power transmission belt, a hose, a track, an air sleeve, and a conveyor belt. The product is preferably a tire.

In another embodiment, the cord reinforced product is a rubber component reinforced by the cord.

The features of the different embodiments and/or aspects of the invention as well as of the description may be combined with one another.

### Brief description of the drawings

Figure 1 is a schematic side view of one embodiment of the present invention;
Figure 2 shows a schematic top view of elements of the device shown in Figure 1, viewed from an upper foil onto the cords to be coated and onto the lower foil;
Figure 3 shows a schematic perspective view of an inventive example of a guiding means including a comb-shaped guide element for guiding wires; and
Figure 4 shows a schematic side view of a series of plasma cord coating devices.

### Detailed description of the invention

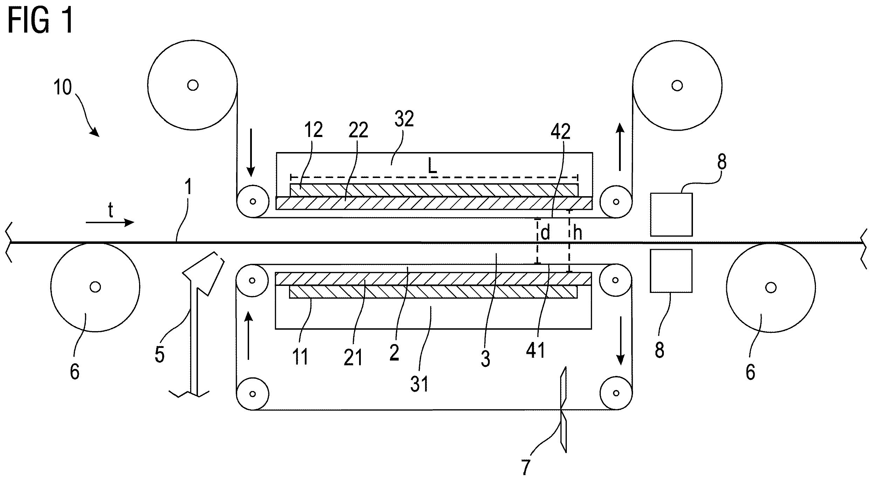

Figure 1 depicts an embodiment of a plasma cord coating device **10** which comprises a first plate electrode **11** and a second plate electrode **12** parallel to the first electrode **11,** a first dielectric barrier **21** and a second dielectric barrier **22** which are parallel to each other and to the electrodes **11, 12.** A gap **2** is formed between the barriers **21** and **22** which cover the electrodes **11, 12.** While the dielectric barriers **21, 22** are shown here in direct contact with the electrodes **11, 12,** there could be also a gap or distance between them. Also, it is possible for the electrodes to be coated with the dielectric barriers (barrier layers) or in the alternative to be fully encapsulated in dielectric barriers.

In the present embodiment illustrated in Figure 1, the backsides of the electrodes **11, 12** are covered by water casings **31, 32** adapted for cooling the backside of the electrodes in order to ensure a constant operating temperature of the electrodes. Demineralized water could be used in such a case. Moreover, the water reservoirs of the water casings could be in fluid contact with a heat exchanger (not shown). It would also be possible that the electrodes **11, 12** and/or the cooling casings **31, 32** are passively cooled by cooling ribs (not shown). Another option would consist of cooling the electrodes by cooling pipes (not shown).

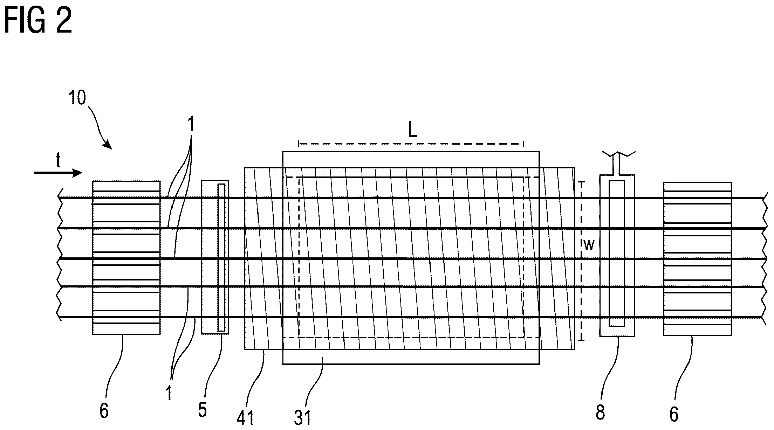

In the gap 2 conveyor foils **41, 42** are arranged to transport material plasma deposited in the device **10** (but not on the cords 1) out of the gap **2.** In particular, upon running a plasma coating/deposition process it would be difficult to coat only the cords **1** without coating also parts of the coating device (called also fouling). This unintended coating of elements of the device would result in frequent maintenance and cleaning to ensure constant coating conditions. In order to minimize such fouling in the device **10,** the inventors have suggested the use of conveyor foils **41, 42** which cover the dielectric barriers **21, 22** in the gap **2** and run essentially in parallel to the dielectric barriers **21, 22** through the gap. The coating foils are comprised, in a preferred example, of a dielectric material with dielectric polymeric materials, such as polyimides, being highly preferred. In fact, polyimides prove to be an excellent choice of material for the plasma conditions. The plasma coating is then carried out between both foils **41, 42** in a plasma treatment zone **3.** Preferably, the plasma treatment zone corresponds to the length of the electrodes L (measured in the transport direction t of the cords) and the width w of the electrodes (visible in Figure 2) and the height d which corresponds to the distance between the two foils **41, 42.** For coating the cords **1,** the plane-parallel cords **1** run through the gap **2,** in particular through the plasma coating zone **3** in parallel to the electrodes **11, 12,** in the transport direction t. Transporting and/or guiding of the cords 1 could be carried out by rollers **6.** Preferably, the width or height h of the gap **2** is constant along the transport direction t so that the distance of the cords **1** to the electrodes **11, 12** is kept constant while running through the gap **1.**

In order to inject a plasma gas into the plasma treatment zone **3** a gas supply means **5** is arranged upstream from the plasma treatment zone **3.** For instance, such a gas supply means **5** could be formed by a slotted tube arranged in a perpendicular manner to the direction of transport t in front of the plasma treatment zone **3.** In an alternative embodiment, a plurality of nozzles could be arranged perpendicular to the direction of transport t and directed towards the plasma treatment zone **3.** In particular, the gas supply means **5** could be provided upstream from a roller which guides one of the foils **41, 42** into the gap **2.**

The gas supply means **5** could inject for instance an atomized mixture including a carrier gas, and a monomer or precursor selected from the group consisting of carbon disulfide and acetylene.

Suitable carrier gas could include for instance any of the noble gases including helium, argon, xenon, and neon. Suitable carrier gases also include nitrogen, carbon dioxide, nitrous oxide, carbon monoxide, and air as well as hydrogen. It is typically preferred for the carrier gas to be a noble gas or nitrogen with noble gases being preferred. In one embodiment, the carrier gas is argon.

As a non-limiting example, the carrier gas may include carrier gas atomized with carbon disulfide and the pure carrier gas introduced directly into the plasma chamber. In one embodiment, the at least one of carbon disulfide and acetylene are present in a ratio (total carbon disulfide + acetylene)/carrier gas in a range of from 0.1 to 5 percent by volume. In one embodiment, the at least one of carbon disulfide and acetylene are present in a ratio (total carbon disulfide + acetylene)/carrier gas in a range of from 0.2 to 1 percent by volume.

In one embodiment, carbon disulfide is used exclusive of acetylene. In one embodiment, acetylene is used exclusive of carbon disulfide. In one embodiment, both carbon disulfide and acetylene are used. In one embodiment, carbon disulfide and acetylene are present in a ratio carbon disulfide/acetylene in a range of 0.1 to 0.5 percent by volume.

In another example of the invention, a carrier gas is fed from a storage vessel to an atomizer along with carbon disulfide from another storage vessel. Carrier gas and carbon disulfide are atomized in an atomizer to form an atomized mixture. Acetylene from a storage vessel and the atomized mixture are mixed into a stream of carrier gas to form a gas mixture. The gaseous mixture may then be sent to the gas supply means 5, injecting the gaseous mixture into the plasma treatment zone **3,** where atmospheric plasma is generated from the gas mixture. In one alternative embodiment, carbon disulfide is not used and no atomized mixture is formed. In another alternative embodiment, acetylene is not used.

Apart from the above described examples of forming a gaseous mixture for injection into the plasma treatment zone, other methods of mixing and/other materials may be used. The specific materials are not within the main focus of the present invention. Further examples of suitable gaseous materials are for instance known from and listed in United States Patent Application Publications US2018/0294069A1, US2018/0294070 as well as in United States Patents US 9,433,971, US 9,133360 and US 9,441,325, which are all incorporated herein by reference for the purpose of disclosing suitable gaseous materials that can be utilized.

Typically, the foils **41, 42** may be continuously moving through the gap **2,** thereby removing continuously material plasma deposited onto the foils **41, 42** out of the gap **2.** In an example, each foil could be an endless band (as foil **41** in Figure 1) which is cleaned at a position outside of the gap **2** by a scraper **7** and/or chemical treatment (not shown) such that the respective foil enters the gap **2** after being cleaned. In another example, a foil may be uncoiled from a first roll or spool and recoiled by a second roll or spool (such as foil **42** in Figure 1). In both alternatives, a clean foil **41, 42** enters or reenters the gap **2** so as to support constant plasma deposition conditions.

While the foils **41, 42** ensure a removal of fouling from the device, it is also desirable to remove remainders of the plasma gas which exit the treatment zone **3** downstream from the electrodes. For this purpose, exhaust means 8 are preferably provided downstream from the gap **2.** Such means could comprise a pipe having apertures which are arranged perpendicularly to the direction of transport t, and preferably in parallel to the planar electrodes **41, 42.** The exhaust **8** may be fluidly connected with a filter device (not shown) which may include one or more filters. In an example, a first filter mechanically filters particles out of the exhaust gas. In addition, or alternatively, a second filter could be an active carbon filter. In addition, or alternatively a third filter could be a high efficiency particulate air (HEPA) filter. The combination of one or more of such filters can efficiently filter the gas received downstream from the plasma treatment zone **3** so that it can be released to the environment in a manner that complies with stringent environmental standards.

Figure 1 shows essentially a horizontal arrangement of electrodes **11, 12,** dielectric barriers **21, 22** and foils **41, 42.** It is emphasized that other orientations of the system would be possible such as vertical or other orientations in between horizontal and vertical.

Figure 2 schematically depicts a top view from the upper foil **42** of Figure 1 onto the cords **1** and the lower foil **41.** Also visible are the rollers **6,** the (plasma) gas supply means **5** (or in other words the supply means **5** for a gaseous mixture such as described herein above), the lower water casing **31** and the exhaust means **8.** Figure 2 shows also a plane-parallel arrangement of the cords **1.** According to the preferred embodiment shown in Figure 2, the cords **1** are held or guided by circumferential grooves in the rollers **6** such that the cords **1** are transported in parallel to one another in the transport direction t. In the present example, five cords **1** are transportable at the same time through the plasma treatment zone. As visible in Figure 2, the foil **41** completely covers the first dielectric barrier and the first electrode (having the width w) embedded in the casing **31** such that plasma coating material which is not caught by or deposited on the cords is deposited on the moving foil **41** and transported out of the gap **2.**

In general, the plate electrodes **11, 12** may be connected to a voltage supply. Supply of voltage electricity to the plate electrodes **11, 12** can generate an atmospheric pressure plasma from the gas supplied by the gas supply means **5** into the plasma treatment zone **3,** in particular for the example of coating grounded metal cords (e.g. made of steel).

In general, the cords **1** may be taken from supply spools (not shown) prior to entry into the plasma treatment zone **3** and may be then wound onto storage spools (not shown) after exiting the plasma treatment zone. One or more of such spools could be motor driven, e.g. to pull cords **1** through the plasma treatment zone **3.** In other embodiments, the transporting means may include drive rollers or other the like. In particular, one or more of rolls **6** could be driven.

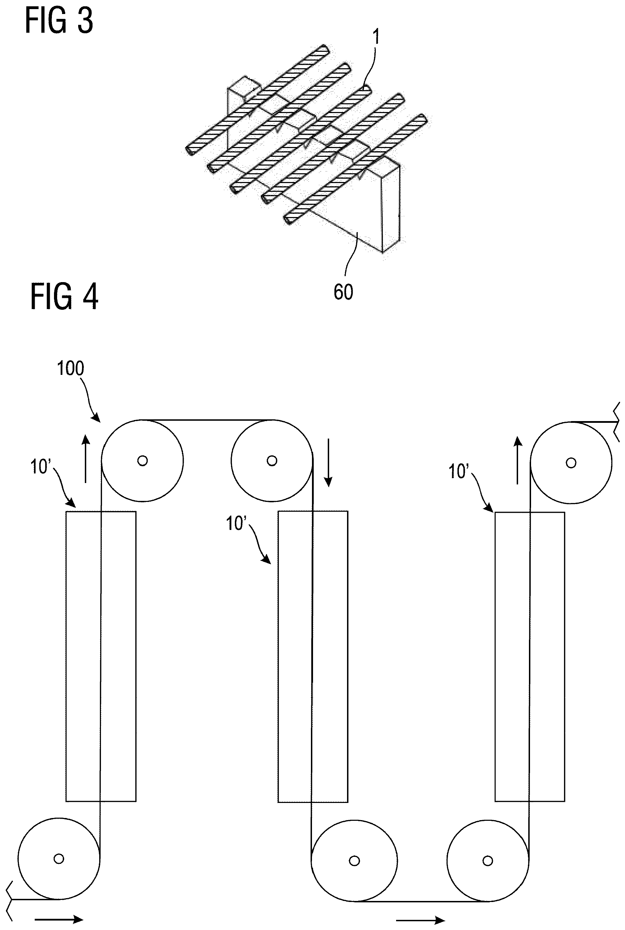

Figure 3 shows a further example of a cord guiding means in the form of a plate having a comb-shape **60** with a plurality of teeth, wherein multiple cords **1** are held in parallel between the teeth within a plane. Optionally, guiding means may be electrically grounded. Such guiding means helps to ensure a proper entry of the wires into the plasma treatment zone **3.** They could be arranged at multiple positions upstream and/or downstream the plasma treatment zone **3.**

As shown in the embodiment of Figure 4, multiple plasma cord coating devices **10'** may be arranged in series in a system **100** to extend the exposure of cords **1** to plasma. For instance, rollers and/or guides, such as rollers **6** and/or guiding means **60** shown in Figures 1 to 3 could be used. In such an embodiment, the plasma cord coating devices **10'** may operate in identical fashion or apply different coatings in sequence as desired, for example by receiving different gas compositions.

Cords 1 may be constructed of various metallic or textile materials, in particular those commonly used in reinforcing cords for tires. In one embodiment, the reinforcement cord includes steel, stainless steel, galvanized steel, zinc plated steel and brass plated steel. Textile materials may include polyesters, such as polyethylene terephthalate or polyethylene naphthalate. The textile material can also be a polyamide, such as nylon-6,6, nylon-4,6. nylon-6,9, nylon-6,10, nylon 6,12, nylon-6, nylon-11, or nylon-12. In some embodiments of this invention hybrid materials, such various blends of polyamides and blends of polyesters can be utilized. The textile material can also be an aramid fiber, a glass fiber, cellulosic fiber (such as Rayon) or another known textile cord material.

## Claims

1. A plasma cord coating device (10) comprising:
a pair of opposite and parallel plate electrodes having a first electrode (11) and a second electrode (12);
a pair of planar and parallel dielectric barriers including a first dielectric barrier (21) and a second dielectric barrier (22), wherein the first electrode (11) is covered by the first dielectric barrier (21) on a side facing the second electrode (12) and the second electrode (12) is covered by the second dielectric barrier (22) on a side facing the first electrode (11) so as to form a gap (2) between the first and the second dielectric barriers (21, 22);
a pair of driven conveyor foils comprising a first foil (41) and a second foil (42), wherein the first foil (41) extends through the gap (2) and covers the first dielectric (21) barrier and the second foil (42) extends through the gap (2) and covers the second dielectric barrier (22) so as to form a plasma treatment zone (3) between the first foil (41) and the second foil (42);
transport means for continuously transporting, in a direction of transport (t) and spaced apart from the first foil (41) and the second foil (42), at least one cord (1) through the plasma treatment zone (3); and
a gas supply means (5) for directing gas into the plasma treatment zone (3), wherein said gas supply means (5) is positioned upstream the plasma treatment zone (3) with respect to the direction of transport (t).

2. The cord coating device according to claim 1, wherein the transport means are adapted to transport at least two spaced apart and plane-parallel cords (1) in parallel to the first and the second electrodes (11, 12) and spaced apart from the first foil (41) and the second foil (42), through the plasma treatment zone (3).

3. The cord coating device according to claim 1 or 2, wherein
a first roller is arranged upstream of the gap (2) for guiding the first foil (41) into the gap (2) and wherein a second roller is arranged upstream of the gap (2) for guiding the second foil (42) into the gap (2), and wherein the gas supply means (5) is optionally positioned upstream of the first and the second rollers; and/or
at least one of the foils (41, 42) is a closed band guided endlessly over at least two rollers into the gap (2) and out of the gap (2); and/or
at least one of the foils (41, 42) is unwindable from a first storage roll and is recoilable on a second storage roll.

4. The cord coating device according to one or more of the preceding claims, wherein
the gas supply means (5) comprises one or more of: a slot arranged perpendicularly to the direction of transport (t), a plurality of nozzles arranged perpendicularly to the direction of transport (t); and/or
the device further comprises exhaust means (8) downstream the gap (2).

5. The cord coating device according to one or more of the preceding claims, wherein
at least one of the electrodes (11, 12) is cooled by cooling means on a backside of the electrode opposite to the gap (2), wherein a backside of the electrode is in direct contact with a cooling water reservoir; and/or
a distance between the first electrode (11) and the second electrode (12) is adjustable; and/or
at least one of i) the first electrode and the first dielectric barrier, and ii) the second electrode and the second dielectric barrier, is mounted on a movable support allowing adjusting a height (h) of the gap (2).

6. The cord coating device according to one or more of the preceding claims, wherein
the foils (41, 42) are made of a dielectric material; and/or
at least one of the foils (41, 42) is made of one or more of: polyimide, PET, polyamide-based polymers, fluorinated polymers, silicone-based polymers, and polyester; and/or
the foils cover at least the whole width (w) of the electrodes (11, 12).

7. The cord coating device according to one or more of the preceding claims, further comprising:
at least two cords (1) extending in parallel and coplanar through the gap with an equal distance to the first electrode (11) and the second electrode (12); and/or
cord guiding means arranged upstream and/or downstream of the gap (2), wherein the cord guiding means comprise a comb-shaped guide (60) having a plurality of teeth for holding cords (1) spaced apart and at essentially equal height between the teeth, and wherein the cord guiding means are optionally electrically grounded and optionally in electrically conductive contact with the transported cord; and/or
means for grounding at least one of the electrodes (11, 12) and/or the cords (1) to be coated; and/or
a power supply connected to at least one of the electrodes (11, 12).

8. A method of plasma treating at least one cord (1) which comprises passing the cord (1) through the plasma treatment zone (3) of the cord coating device (10) according to one or more of the preceding claims.

9. The method according to claim 8, wherein the cord (1) is a tire cord.

10. The method according to claim 8 or 9, wherein the cord (1) is a metal cord (1).

11. The method according to claim 8 or 9, wherein the cord (1) is a polymeric cord and/or a textile cord.

12. The method according to one or more of claims 8 to 11, wherein multiple cords (1) are transported plane-parallelly and in parallel to the electrodes (11, 12) through the plasma treatment zone (3) and are spaced apart from each other and spaced apart from the conveyor foils (41, 42).

13. The method according to one or more of claims 8 to 12, wherein the cords (1) are transported through the plasma treatment zone (3) at a speed which is within the range from 1 m/min to 100 m/min.

## Patentansprüche

1. Plasmakordbeschichtungsvorrichtung (10), umfassend:
ein Paar von gegenüberliegenden und parallelen Plattenelektroden, das eine erste Elektrode (11) und eine zweite Elektrode (12) hat;
ein Paar von ebenen und parallelen dielektrischen Barrieren, das eine erste dielektrische Barriere (21) und eine zweite dielektrische Barriere (22) enthält, wobei die erste Elektrode (11) durch die erste dielektrische Barriere (21) auf einer der zweiten Elektrode (12) zugewandten Seite abgedeckt wird und die zweite Elektrode (12) durch die zweite dielektrische Barriere (22) auf einer der ersten Elektrode (11) zugewandten Seite abgedeckt wird, um so einen Spalt (2) zwischen der ersten und der zweiten dielektrischen Barriere (21, 22) zu bilden;
ein Paar von angetriebenen Förderfolien, das eine erste Folie (41) und eine zweite Folie (42) umfasst, wobei die erste Folie (41) sich durch den Spalt (2) erstreckt und die erste dielektrische Barriere (21) abdeckt und die zweite Folie (42) sich durch den Spalt (2) erstreckt und die zweite dielektrische Barriere (22) abdeckt, um so eine Plasmabehandlungszone (3) zwischen der ersten Folie (41) und der zweiten Folie (42) zu bilden;
Transportmittel zum kontinuierlichen Transport von mindestens einem Kord (1) in Transportrichtung (t) und im Abstand von der ersten Folie (41) und der zweiten Folie (42) durch die Plasmabehandlungszone (3); und
ein Gasversorgungsmittel (5) zum Leiten von Gas in die Plasmabehandlungszone (3), wobei dieses Gasversorgungsmittel (5) der Plasmabehandlungszone (3) bezüglich der Transportrichtung (t) vorgeschaltet ist.

2. Kordbeschichtungsvorrichtung nach Anspruch 1, wobei die Transportmittel dazu eingerichtet sind, mindestens zwei beabstandete und planparallele Korde (1) parallel zu der ersten und der zweiten Elektrode (11, 12) und beabstandet von der ersten Folie (41) und der zweiten Folie (42) durch die Plasmabehandlungszone (3) zu transportieren.

3. Kordbeschichtungsvorrichtung nach Anspruch 1 oder 2, wobei eine erste Führungsrolle stromaufwärts des Spalts (2) zur Führung der ersten Folie (41) in den Spalt (2) angeordnet ist und wobei eine zweite Führungsrolle stromaufwärts des Spalts (2) zur Führung der zweiten Folie (42) in den Spalt (2) angeordnet ist, und wobei das Gasversorgungmittel (5) optional der ersten und der zweiten Führungsrolle vorgeschaltet ist; und/oder
mindestens eine der Folien (41, 42) ein geschlossenes Band ist, das über mindestens zwei Führungsrolle endlos in den Spalt (2) und aus dem Spalt (2) geführt wird; und/oder
mindestens eine der Folien (41, 42) von einer ersten Speicherrolle abwickelbar und auf eine zweite Speicherrolle wiedereinziehbar ist.

4. Kordbeschichtungsvorrichtung nach einem oder mehreren der vorhergehenden Ansprüche, wobei
das Gasversorgungmittel (5) eines oder mehrere von: einem senkrecht zur Transportrichtung (t) angeordneten Schlitz, mehreren senkrecht zur Transportrichtung (t) angeordneten Düsen; und/oder
die Vorrichtung ferner stromabwärts dem Spalt (2) Auslassmittel (8) umfasst.

5. Kordbeschichtungsvorrichtung nach einem oder mehreren der vorhergehenden Ansprüche, wobei
mindestens eine der Elektroden (11, 12) an einer dem Spalt (2) gegenüberliegenden Rückseite der Elektrode durch Kühlmittel gekühlt wird, wobei eine Rückseite der Elektrode in direktem Kontakt mit einem Kühlwasserbehälter steht, und/oder
ein Abstand zwischen der ersten Elektrode (11) und der zweiten Elektrode (12) einstellbar ist; und/oder
mindestens eines von i) der ersten Elektrode und der ersten dielektrischen Barriere und ii) der zweiten Elektrode und der zweiten dielektrischen Barriere auf einem beweglichen Träger angebracht ist, der eine Verstellung der Höhe (h) des Spaltes (2) ermöglicht.

6. Kordbeschichtungsvorrichtung nach einem oder mehreren der vorhergehenden Ansprüche, wobei
die Folien (41, 42) aus einem dielektrischen Material bestehen und/oder
mindestens eine der Folien (41, 42) aus einem oder mehreren der folgenden Materialien besteht: Polyimid, PET, Polymeren auf Polyamidbasis, fluorierten Polymeren, Polymeren auf Silikonbasis und Polyester und/oder
die Folien mindestens die gesamte Breite (w) der Elektroden (11, 12) abdecken.

7. Kordbeschichtungsvorrichtung nach einem oder mehreren der vorhergehenden Ansprüche, die ferner umfasst:
mindestens zwei sich parallel und koplanar durch den Spalt erstreckende Korde (1) mit gleichem Abstand zur ersten Elektrode (11) und zur zweiten Elektrode (12); und/oder
stromaufwäts und/oder stromabwärts des Spalts (2) angeordnete Kordführungsmittel, wobei die Kordführungsmittel eine kammförmige Führung (60) mit einer Vielzahl von Zähnen zum Halten von Korden (1) haben, die beabstandet sind und im Wesentlichen auf gleicher Höhe zwischen den Zähnen liegen, und wobei die Kordführungsmittel optional elektrisch geerdet und optional in elektrisch leitendem Kontakt mit der transportierten Kord stehen; und/oder
Mittel zur Erdung mindestens einer der Elektroden (11, 12) und/oder des zu beschichtenden Kordes (1); und/oder
eine an mindestens eine der Elektroden (11, 12) angeschlossene Spannungsversorgung.

8. Verfahren zur Plasmabehandlung mindestens eines Kordes (1), das das Führen des Kords (1) durch die Plasmabehandlungszone (3) der Kordbeschichtungsvorrichtung (10) gemäß einem oder mehreren der vorhergehenden Ansprüche umfasst.

9. Verfahren nach Anspruch 8, wobei der Kord (1) ein Reifenkord ist.

10. Verfahren nach Anspruch 8 oder 9, wobei der Kord (1) ein Metallkord (1) ist.

11. Verfahren nach Anspruch 8 oder 9, wobei der Kord (1) ein polymerer Kord und/oder ein textiler Kord ist.

12. Verfahren nach einem oder mehreren der Ansprüche 8 bis 11, wobei mehrere Korde (1) parallel und parallel zu den Elektroden (11, 12) durch die Plasmabehandlungszone (3) flächig durch die Plasmabehandlungszone (3) transportiert werden und voneinander beabstandet und von den Förderfolien (41, 42) beabstandet sind.

13. Verfahren nach einem oder mehreren der Ansprüche 8 bis 12, wobei die Korde (1) mit einer Geschwindigkeit von 1 m/min bis 100 m/min durch die Plasmabehandlungszone (3) transportiert werden.

## Revendications

1. Dispositif de revêtement de câblé par plasma (10) qui comprend :
une paire d'électrodes opposées et parallèles en forme de plaques possédant une première électrode (11) et une deuxième électrode (12) ;
une paire de boucliers diélectriques parallèles et de forme plane, qui englobe un premier bouclier diélectrique (21) et un deuxième bouclier diélectrique (22) ; dans lequel la première électrode (11) est recouverte par le premier bouclier diélectrique (21) sur un côté faisant face à la deuxième électrode (12) et la deuxième électrode (12) est recouverte par le deuxième bouclier diélectrique (22) sur un côté faisant face à la première électrode (11) de manière à former un espace libre (2) entre le premier et le deuxième bouclier diélectrique (21, 22) ;
une paire de dispositifs de transport faisant office de convoyeurs comprenant une première feuille (41) et une deuxième feuille (42) ; dans lequel la première feuille (41) s'étend à travers l'espace libre (2) et recouvre le premier bouclier diélectrique (21) et la deuxième feuille (42) s'étend à travers l'espace libre (2) et recouvre le deuxième bouclier diélectrique (22) de façon à obtenir une zone de traitement par plasma (3) entre la première faille (41) et la deuxième feuille (42) ;
des moyens de transport destinés à transporter en continu, dans une direction de transport (t) et à l'écart de la première feuille (41) et de la deuxième feuille (42), au moins un câblé (1) à travers la zone de traitement par plasma (3) ; et
un moyen d'alimentation de gaz (5) destiné à diriger du gaz jusque dans la zone de traitement par plasma (3) ; dans lequel ledit moyen d'alimentation de gaz (5) est disposé en amont de la zone de traitement par plasma (3) par rapport à la direction de transport (t).

2. Dispositif de revêtement de câblé par plasma selon la revendication 1, dans lequel les moyens de transport sont conçus pour transporter en parallèle par rapport à la première et à la deuxième électrode (11, 12) et à l'écart de la première feuille (41) et de la deuxième feuille (42) au moins deux câblés (1) espacés l'un de l'autre et parallèles en plan, à travers la zone de traitement par plasma (3).

3. Dispositif de revêtement de câblé par plasma selon la revendication 1 ou 2, dans lequel
un premier galet est disposé en amont de l'espace libre (2) à des fins de guidage de la première feuille (41) jusque dans l'espace libre (2) ; et dans lequel un deuxième galet est disposé en amont de l'espace libre (2) à des fins de guidage de la deuxième feuille (42) jusque dans l'espace libre (2) ; et dans lequel le moyen d'alimentation de gaz (5) est disposé, de manière facultative, en amont du premier et du deuxième galet ; et/ou
au moins une des feuilles (41, 42) représente une bande fermée qui est guidée sans fin par-dessus au moins deux galets jusque dans l'espace libre (2) et à l'extérieur de l'espace libre (2) ; et/ou
au moins une des feuilles (41, 42) peut être déroulée à partir d'un premier rouleau de stockage et peut être réenroulée sur un deuxième rouleau de stockage.

4. Dispositif de revêtement de câblé par plasma selon une ou plusieurs des revendications précédentes, dans lequel
le moyen d'alimentation de gaz (5) comprend un ou plusieurs éléments choisis parmi : une fente qui est disposée perpendiculairement à la direction de transport (t) ; plusieurs buses qui sont disposées perpendiculairement à la direction de transport (t) ; et/ou
le dispositif comprend en outre des moyens d'évacuation (8) en aval de l'espace libre (2).

5. Dispositif de revêtement de câblé par plasma selon une ou plusieurs des revendications précédentes, dans lequel
au moins une des électrodes (11, 12) est refroidie par l'intermédiaire d'un moyen de refroidissement sur un côté arrière de l'électrode opposé à l'espace libre (2) ; dans lequel le côté arrière de l'électrode est mis en contact direct avec un réservoir d'eau de refroidissement ; et/ou
une distance qui sépare la première électrode (11) et la deuxième électrode (12) peut être réglée ; et/ou
au moins un des éléments ci-après choisis parmi i) la première électrode et le premier bouclier diélectrique, et ii) la deuxième électrode et le deuxième bouclier diélectrique, est montée sur un support mobile qui permet de régler une hauteur (h) de l'espace libre (2).

6. Dispositif de revêtement de câblé par plasma selon une ou plusieurs des revendications précédentes, dans lequel
les feuilles (41, 42) sont constituées d'un matériau diélectrique ; et/ou
au moins une des feuilles (41, 42) est réalisée à partir d'un ou de plusieurs éléments choisis parmi : du polyimide, du PET, des polymères à base de polyamide, des polymères fluorés, des polymères à base de silicone et du polyester ; et/ou
les feuilles recouvrent au moins l'entièreté de la largeur (w) des électrodes (11, 12).

7. Dispositif de revêtement de câblé par plasma selon une ou plusieurs des revendications précédentes, comprenant
au moins deux câblés (1) s'étendant en parallèle et en position coplanaire à travers l'espace libre à une distance égale par rapport à la première électrode (11) et à la deuxième électrode (12) ; et/ou
des moyens de guidage de câblés qui sont disposés en amont et/ou en aval de l'espace libre (2) ; dans lequel les moyens de guidage de câblé comprennent un guide en forme de peigne (60) qui possède plusieurs dents destinées à maintenir les câblés (1) à l'écart les uns des autres et une hauteur essentiellement égale entre les dents ; et dans lequel les moyens de guidage de câblé sont de manière facultative mis électriquement à la terre et de manière facultative sont mis en contact électroconducteur avec le câblé transporté ; et/ou
des moyens destinés à la mise à la terre d'au moins une des électrodes (11, 12) et/ou des câblés (1) qui doivent être revêtus ; et/ou
une alimentation en courant qui est reliée à au moins une des électrodes (11, 12).

8. Procédé de traitement par plasma d'au moins un câblé (1) qui comprend le fait de faire passer le câblé (1) à travers la zone de traitement par plasma (3) du dispositif de revêtement de câblé (10) en conformité avec une ou plusieurs des revendications précédentes.

9. Procédé selon la revendication 8, dans lequel le câblé (1) est un câblé de bandage pneumatique.

10. Procédé selon la revendication 8 ou 9, dans lequel le câblé (1) est un câblé métallique (1).

11. Procédé selon la revendication 8 ou 9, dans lequel le câblé (1) est un câblé polymère et/ou un câblé en textile.

12. Procédé selon une ou plusieurs des revendications 8 à 11, dans lequel plusieurs câblés (1) sont transportés parallèlement à un plan et en parallèle par rapport aux électrodes (11, 12) à travers la zone de traitement par plasma (3) et sont espacés les uns des autres et espacés par rapport aux feuilles faisant office de convoyeurs (41, 42).

13. Procédé selon une ou plusieurs des revendications 8 à 12, dans lequel les câblés (1) sont transportés à travers la zone de traitement par plasma (3) à une vitesse qui se situe dans la plage allant de 1 m/min à 100 m/min.
